# DEMANDE DE BREVET EUROPEEN

(11) **EP 4 199 109 A1**
(43) Date de publication de la demande: **21.06.2023**
(21) Numéro de dépôt: 22211736.8
(22) Date de dépôt: 06.12.2022
(51) Int. Cl.: H01L 29/423, H01L 29/66, H01L 29/06, H01L 21/78, B82Y 10/00

(54) **GRILLE ARRIERE POUR DISPOSITIF QUANTIQUE**

(30) Priorité: 16.12.2021 FR 2113677
(71) Demandeur: Commissariat à l'énergie atomique et aux énergies alternatives, 75015 Paris (FR)
(72) Inventeur: CHARBONNIER, Jean, 38054 GRENOBLE CEDEX 09 (FR); ASSOUS, Myriam, 38054 GRENOBLE CEDEX 09 (FR); BEDECARRATS, Thomas, 38054 GRENOBLE CEDEX 09 (FR); RAMBAL, Nils, 38054 GRENOBLE CEDEX 09 (FR); VINET, Maud, 38054 GRENOBLE CEDEX 09 (FR)
(74) Mandataire: Brevalex

(57) **Abrégé**

Réalisation d'un dispositif quantique à Qbits de spin comprenant un substrat de type semi-conducteur sur isolant, le substrat étant doté d'une couche semi-conductrice superficielle (12), la couche semi-conductrice superficielle étant disposée sur une couche isolante (11), la couche isolante étant agencée sur une face supérieure d'une couche de support semi-conductrice (10). Le dispositif est muni d'au moins un composant formé d'un ou plusieurs ilots quantiques s'étendant dans la couche semi-conductrice superficielle (12), les ilots quantiques sont induits par des électrodes de grilles (20A, 20B), dites avants, contrôlant l' électrostatique des ilots quantiques et étant disposées sur la couche semi-conductrice superficielle. En plus le composant est doté en outre d'une grille de contrôle électrostatique arrière, ladite grille de contrôle arrière étant formée d'une couche conductrice (119) tapissant des parois latérales et un fond d'une ouverture (517) traversant ladite couche de support semi-conductrice depuis une face inférieure de ladite couche de support opposée à ladite face supérieure jusqu'à ladite couche isolante (11) du substrat, ladite couche conductrice (119) étant disposée, au fond de l'ouverture (517), contre et avantageusement en contact avec ladite couche isolante du substrat, ladite couche conductrice (119) étant disposée contre et en contact avec ladite couche de support semi-conductrice au niveau desdites parois latérales de ladite ouverture. L'ouverture (517) dans laquelle la grille arrière est formée est gravée de manière concomitante avec des tranchées de découpage (111).

## Description

### DOMAINE TECHNIQUE

La présente demande concerne le domaine des dispositifs électroniques et en particulier celui des dispositifs quantiques formés d'ilots semi-conducteurs et utilisant, outre des électrodes de grille avant situées au-dessus des ilots, au moins une électrode de contrôle arrière agencée en dessous du niveau dans lequel les ilots se situent.

### ÉTAT DE LA TECHNIQUE ANTÉRIEURE

Les îlots quantiques (parfois également appelées boîtes ou points quantiques) forment des éléments de base d'un dispositif électronique quantique. Les îlots quantiques sont typiquement formés dans une couche de matériau semi-conducteur dans laquelle des puits de potentiel sont mis en œuvre pour confiner des porteurs, électrons ou trous, dans les trois dimensions de l'espace. Une information quantique est alors codée par le biais du spin du porteur. On parle alors de Qbits (ou qubit) de spin.

Selon une approche, des électrons sont confinés par effet de champ sous des électrodes de grilles semblables à celles des structures de transistors et l'information est encodée dans le spin de ces électrons. Ces grilles dites « avant » sont disposées au-dessus de l'ensemble des ilots quantiques.

La possibilité d'appliquer un potentiel sous une couche d'isolation, ou un oxyde enterré (BOX), ou plutôt une grille arrière appelée « Back gate » permet d'ajuster la profondeur du puit de potentiel et ainsi de mieux maîtriser le profil de potentiel et donc la manipulation des électrons et de leurs spins.

La grille arrière est une électrode supplémentaire située au-dessous de l'ensemble des ilots quantiques.

Ce type de dispositif quantique fonctionne généralement à très basse température ce qui implique que si l'on souhaite réaliser la grille arrière en matériau semi-conducteur, celui-ci doit être très fortement dopé afin que la grille puisse être conductrice et fonctionnelle.

Or, doper très fortement un substrat par implantation ionique risque d'induire des dopants résiduels ou de générer des défauts cristallins dans une couche semi-conductrice dans laquelle les ilots sont prévus. Cela n'est pas compatible avec un fonctionnement correct d'un dispositif quantique.

Une autre méthode qui inclurait une étape de report de plaque avec une zone déjà dopée pour réaliser la grille arrière présenterait quant à elle l'inconvénient d'être complexe à mettre en œuvre et d'induire une variabilité de procédé importante.

Une autre méthode qui consisterait à réaliser la grille arrière par structuration de la face arrière puis formation d'un via conducteur pose quant à elle problème en termes de contraintes mécaniques exercées sur la structure.

Il se pose le problème de trouver un dispositif quantique doté d'au moins un composant muni d'une électrode de contrôle arrière ainsi qu'un procédé de réalisation d'un tel dispositif et qui soient améliorés vis-à-vis d'inconvénients énoncés ci-dessus.

### EXPOSÉ DE L'INVENTION

C'est par conséquent un but de la présente invention d'offrir un dispositif quantique à Qbits de spin comprenant un substrat de type semi-conducteur sur isolant, le substrat étant doté d'une couche semi-conductrice superficielle, la couche semi-conductrice superficielle étant disposée sur une couche isolante, la couche isolante étant agencée sur une face supérieure d'une couche de support semi-conductrice, le dispositif étant muni d'au moins un composant formé d'un ou plusieurs ilots quantiques s'étendant dans la couche semi-conductrice superficielle et d'une ou plusieurs électrodes de grilles dites « avant » pour le contrôle électrostatique des ilots quantiques, lesdites électrodes de grilles avant étant disposées sur la couche semi-conductrice superficielle, le composant C étant doté en outre d'une grille de contrôle électrostatique dite « arrière », ladite grille de contrôle arrière étant formée d'une couche conductrice tapissant des parois latérales et un fond d'une ouverture traversant ladite couche de support semi-conductrice depuis une face inférieure de ladite couche de support opposée à ladite face supérieure jusqu'à ladite couche isolante du substrat, ladite couche conductrice étant disposée, au fond de l'ouverture contre et avantageusement en contact avec ladite couche isolante du substrat, ladite couche conductrice étant disposée contre et en contact avec ladite couche de support semi-conductrice au niveau desdites parois latérales de ladite ouverture.

Un tel agencement de grille arrière permet un contrôle au plus près des ilots tout en permettant de conserver une bonne tenue mécanique et en particulier en préservant le dispositif de contraintes mécaniques trop importantes.

Avantageusement, ladite ouverture comporte un volume vide, c'est à dire non rempli ou rempli d'air, et qui s'étend de la couche conductrice jusqu'à une embouchure de ladite ouverture.

Selon une possibilité de mise en œuvre, la couche conductrice s'étend en outre au-delà de ladite ouverture sur ladite face inférieure de la couche de support.

La couche conductrice peut s'étendre sur une région donnée de ladite face inférieure de la couche de support et peut être structurée de sorte à comporter des motifs sur cette région donnée.

Selon un mode de réalisation particulier ladite ouverture peut avoir une forme évasée dudit fond jusqu'à une embouchure de ladite ouverture et prévue sorte que lesdites parois latérales de l'ouverture sont inclinées par rapport à une normal à un plan principal de ladite couche de support. Dans ce cas, l'ouverture peut avoir une forme évasée dudit fond jusqu'à une embouchure de ladite ouverture.

Selon une possibilité de mise en œuvre, la couche conductrice peut être formée d'un empilement comprenant une couche d'accroche conductrice, et une couche métallique en un matériau ayant des propriétés supra-conductrices.

Selon un autre aspect, la présente invention prévoit un procédé de fabrication d'un dispositif tel que défini précédemment.

La présente invention concerne en particulier un procédé de fabrication d'un dispositif quantique à Qbits de spin tel que défini précédemment et comprenant, dans cet ordre, des étapes consistant à :
a) prévoir ou réaliser une structure comprenant, ledit substrat muni desdits un ou plusieurs ilots quantiques s'étendant dans la couche semi-conductrice superficielle et des une ou plusieurs grilles de contrôle électrostatique avant des ilots quantiques disposées sur la couche semi-conductrice superficielle,
b) former, à travers la face inférieure de la couche de support, l'ouverture puis,
c) déposer la couche conductrice dans l'ouverture de sorte à former la grille de contrôle électrostatique arrière.

Avantageusement, le procédé peut comprendre en outre : la réalisation d'un ou plusieurs trous ou tranchées de découpe dans la couche de support de sorte à réaliser un chemin de découpe dans la couche de support.

Selon une possibilité de mise en œuvre, les un ou plusieurs trous ou tranchée(s) de découpe peuvent réaliser un contour autour de l'ouverture.

De manière avantageuse, la réalisation des un ou plusieurs trous de découpe ou tranchées de découpe dans la couche de support et la formation de l'ouverture peuvent être réalisées par gravure et de manière concomitante.

Selon une possibilité de mise en œuvre, le dépôt de la couche conductrice peut être réalisé également dans les un ou plusieurs trous ou tranchée(s) de découpe.

Le procédé peut alors comprendre en outre des étapes de :
- formation d'un masquage recouvrant ladite ouverture,
- retrait par gravure de la couche conductrice en regard du ou des trous ou tranchée(s) de découpe tout en protégeant l'ouverture par le biais du masquage.

Avantageusement le procédé peut, comprenant en outre, après l'étape c) des étapes de :
- collage d'une bande adhésive contre la face inférieure ou une couche ou un empilement disposé(e) sur la face inférieure de la couche de support,
- étirement de la bande adhésive de sorte à réaliser une division du substrat au niveau du ou des chemins de découpe.

Selon une possibilité de mise en œuvre, l'ouverture peut être réalisée par gravure profonde à travers un masque.

Typiquement, on réalise un retournement préalable du substrat avant d'effectuer une telle gravure.

Selon une possibilité de réalisation pour laquelle les grilles de contrôle électrostatique avant sont revêtues d'un empilement de couches et pour laquelle entre l'étape a) et l'étape b) on colle un support poignée temporaire sur ledit empilement, le procédé peut comprendre en outre après l'étape c) : une étape de retrait du support temporaire.

### BRÈVE DESCRIPTION DES DESSINS

La présente invention sera mieux comprise sur la base de la description qui va suivre et des dessins en annexe sur lesquels :
La présente invention sera mieux comprise à la lecture de la description d'exemples de réalisation donnés, à titre purement indicatif et nullement limitatif, en faisant référence aux dessins annexés sur lesquels :
La figure 1 sert à illustrer un exemple de composant quantique sur lequel une grille arrière est destinée à être formée et qui est susceptible d'être intégrée à un dispositif quantique tel que mis en œuvre suivant la présente invention ;
Les figures 2A, 2B, 2C, 2D, 2E, 2F, 2G, 2H, 2I, 2J servent à illustrer un exemple de procédé, suivant un mode de réalisation de la présente invention, de fabrication d'un dispositif quantique et d'une grille arrière pour composant quantique ;
Les figures 3A, 3B servent à illustrer une division de substrat afin d'obtenir plusieurs puces élémentaires par étirement d'une bande adhésive collé sur un substrat dans lequel un ou plusieurs chemins de découpe ont été préalablement formés ;
Les figures 4A, 4B, 4C servent à illustrer la mise en œuvre de trous ou tranchées autour de grilles arrière afin de réaliser un chemin de découpe continu ou discontinu ;
La figure 5 sert à illustrer la mise en œuvre d'une ouverture d'accueil évasée pour grille arrière de dispositif quantique ;
La figure 6 sert à illustrer un dispositif quantique muni d'une grille arrière formée dans une ouverture d'accueil évasée pratiquée dans la couche de support semi-conductrice d'un support semi-conducteur sur isolant ;
La figure 7 sert à illustrer des motifs réalisés dans une couche conductrice en face arrière d'un dispositif quantique et connectée à une ou plusieurs grilles arrières ;
Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

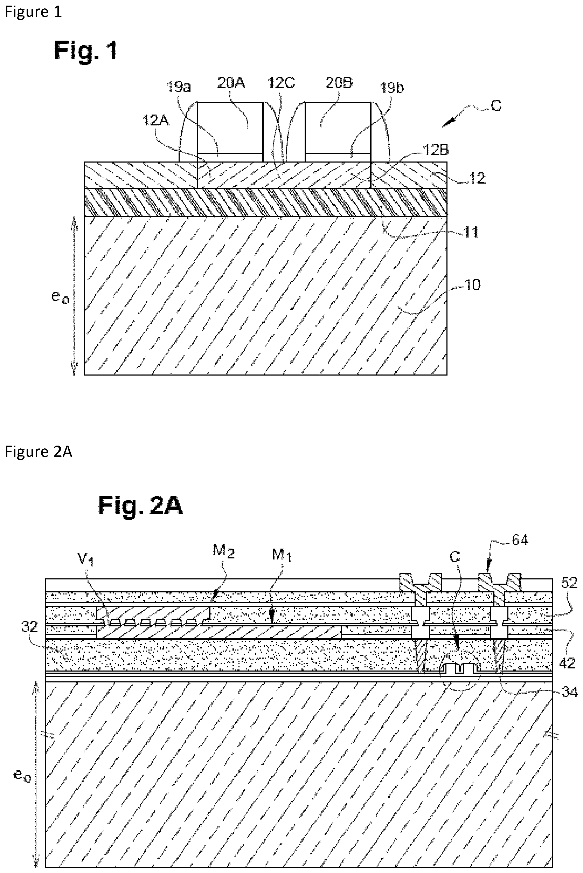

En outre, dans la description ci-après, des termes qui dépendent de l'orientation de la structure tels que « avant », « arrière », « supérieure », « inférieure », « latérale », s'appliquent en considérant que la structure est orientée de la façon illustrée sur les figures 1, 2A, ou 6.

### EXPOSÉ DÉTAILLÉ DE MODES DE RÉALISATION PARTICULIERS

On se réfère tout d'abord à la figure 1 qui donne une vue en coupe d'un exemple de composant C quantique, en particulier à Qbits de spin, en cours de fabrication, et qui est susceptible d'être intégré dans une puce de circuit quantique mise en œuvre suivant l'invention.

Le composant est formé sur un substrat qui peut être de type semi-conducteur sur isolant et qui comporte une couche de support 10 en matériau semi-conducteur, une couche isolante enterrée 11 disposée sur la couche de support 10 et une couche superficielle 12 semi-conductrice disposée sur la couche isolante. Le substrat est typiquement un substrat SOI (« Silicon On Insulator », i.e. Silicium sur isolant) dont la couche superficielle 12 est en silicium, en particulier du ²⁸Si lorsque cette couche est amenée à accueillir des qubits de spin d'électrons. D'autres matériaux semi-conducteurs peuvent être envisagés pour la couche semi-conductrice superficielle 12, en particulier, lorsque cette couche est amenée à accueillir des qubits de spin de trous.

La couche isolante 11 et la couche de support 10 sont typiquement, respectivement, une couche en oxyde de silicium communément appelée de « BOX » (pour « Burried Oxide » ou « oxyde enterré ») et une couche à base de silicium. L'épaisseur de la couche superficielle 12, est par exemple comprise entre environ 5 nm et 50 nm, typiquement de l'ordre de 10 nm. L'épaisseur de la couche isolante enterrée 11 est par exemple comprise entre 10 nm et 200 nm, par exemple de l'ordre de 145 nm.

La couche de support 10 peut quant à elle être prévue par exemple avec une épaisseur eo comprise entre 30 µm et 725 µm, typiquement de 725µm ou 775µm.

Dans le mode de réalisation décrit ici, le composant C comporte au moins deux régions 12A, 12B de confinement situées dans une portion de la couche semi-conductrice superficielle 12, ces régions 12A, 12B étant couplées et juxtaposées, une première de ces régions formant un Qbit, tandis que l'autre région forme un élément de détection. Chaque qubit et élément de détection est doté d'une grille avant, référencée 20a et 20b, chacune des grilles reposant sur un diélectrique de grille 19a, 19b. Les deux régions 12A, 12B de confinement sont ici reliées par l'intermédiaire d'une région 12C de couplage entre les régions de confinement 12A, 12B.

Le couplage quantique entre les régions de confinement 12A, 12B ou plus particulièrement le niveau de potentiel de la barrière tunnel formée par la région 12C peut être modulé grâce à l'apport d'une grille arrière destinée à être formée ultérieurement dans la couche de support 10.

Pour permettre un positionnement précis du composant C par rapport à un emplacement de grille arrière, des marques d'alignement (non représentées) peuvent être prévues sur la face inférieure 10B de la couche de support 10. De telles marques peuvent être détectées par un système optique utilisant un faisceau infra-rouge traversant la couche de support 10.

Après avoir réalisé typiquement une pluralité de composants quantiques du type de celui décrit précédemment, on forme des contacts et éléments de connexion d'un ou plusieurs niveaux d'interconnexion en effectuant une ou plusieurs étape(s) de dépôt(s) de couche isolante(s), par exemple de SiO₂, de réalisation d'ouverture(s) dans cette ou ces couche(s), de dépôt de matériau métallique(s).

Dans l'exemple de réalisation particulier illustré sur la figure 2A, le composant C est ainsi recouvert d'un empilement de couches isolantes comprenant une couche 32 de matériau diélectrique dite « pré-métallique » (PMD), par exemple une couche d'oxyde qui peut être de l'ordre de 400 nm d'épaisseur. On planarise cette couche ou cet empilement par CMP (« Chemical Mechanical Polishing », i.e. polissage mécano-chimique) et des trous sont pratiqués pour former des éléments de connexion 34 en matériau métallique.

La couche 32 de matériau diélectrique dite « pré-métallique » (PMD) est ici recouverte d'autres couches isolantes 42, 52, dans lesquelles un premier niveau métallique M1 et un deuxième niveau métallique M2 d'interconnexion sont dans cet exemple formés avec des éléments de connexion verticaux V1 (communément appelés « vias ») entre les niveaux M1, M2. Les niveaux métalliques sont ici surmontés de plots 64 d'accès conducteurs, par exemple en aluminium affleurant l'empilement de couches isolantes.

On souhaite ensuite former dans la couche de support 10 une ou plusieurs électrodes de grille arrière et en particulier au moins une électrode de grille arrière pour le composant C décrit précédemment.

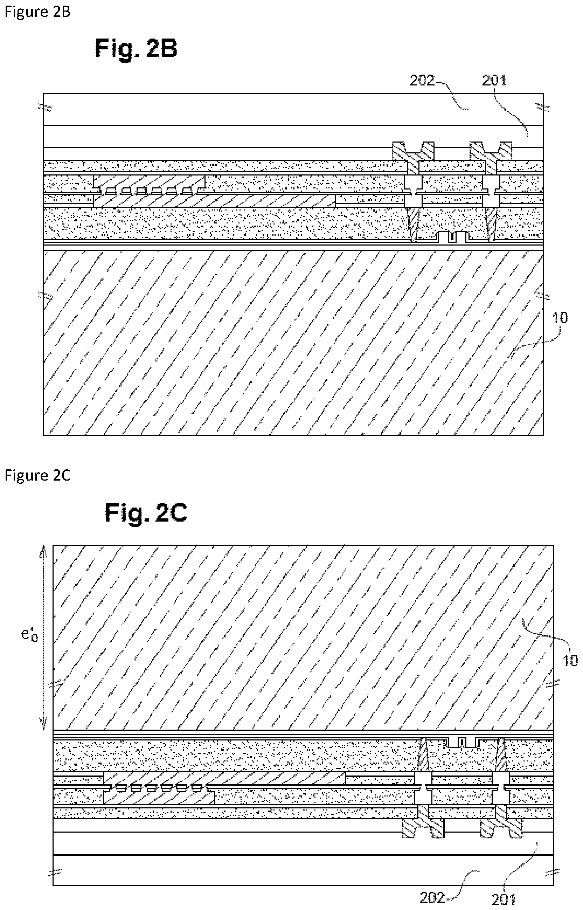

Dans l'exemple de réalisation illustré sur la figure 2B, préalablement à une structuration de la couche de support 10, on accole un support temporaire 202 sur l'empilement de couches isolantes. Le support temporaire 202 est ainsi disposé du côté de la face supérieure du substrat et permet de réaliser une protection et une tenue mécanique de l'ensemble lors de structuration(s) ultérieure(s) de la couche de support 10.

Le support temporaire 202 peut être par exemple en matériau semi-conducteur, en particulier en silicium et peut avoir une épaisseur comprise entre 400 µm et 800 µm, par exemple de l'ordre de 725µm. Le support temporaire 202 peut être assemblé avec le substrat par le biais d'une colle 201, que l'on étale préalablement sur l'empilement dans lequel les éléments de connexion 64, M1, M2, V1, 34 sont formés. Une étape de nettoyage de bords latéraux du substrat est typiquement réalisée après le collage temporaire du support 202.

La colle 201 employée peut être une colle rendue liquide à température élevée, en particulier supérieure à 200°C. On choisit par exemple une colle liquide de type BSIO1A développée par Brewer Science, Inc. (BSI).

Sur la figure 2C (le substrat étant retourné sur cette figure), une étape optionnelle de réduction de l'épaisseur de la couche de support 10, à présent notée e'o et telle que e'₀ < e₀ est effectuée afin de faciliter une structuration ultérieure de cette dernière.

Cette réduction d'épaisseur peut être réalisée en sous étapes successives d'amincissement.

Un premier amincissement d'une épaisseur par exemple de l'ordre de 200 µm peut être effectué. Ce premier amincissement peut être suivi d'un deuxième amincissement d'une épaisseur par exemple de l'ordre de 120 µm.

Entre les amincissements on peut prévoir des étapes de détourage et de mesure d'épaisseur résiduelle.

Chaque amincissement peut comprendre un procédé de gravure ionique réactive profonde (en anglais « Deep Reactive Ion Etching » DRIE). Pour un support 10 en silicium ce procédé est réalisé par exemple en alternant phase de gravure du silicium en utilisant un plasma à base de fluor (Hexafluorure de Soufre SF6) et une phase à base de chimie flurocarbonée.

On conserve par exemple une épaisseur e'ode la couche de support 10 comprise entre 30 et 200 µm, avantageusement entre 120 µm et 180 µm.

On réalise ensuite une ou plusieurs ouverture(s) dans la couche de support 10 notamment afin de former un ou plusieurs emplacement(s) de grille(s) arrière(s).

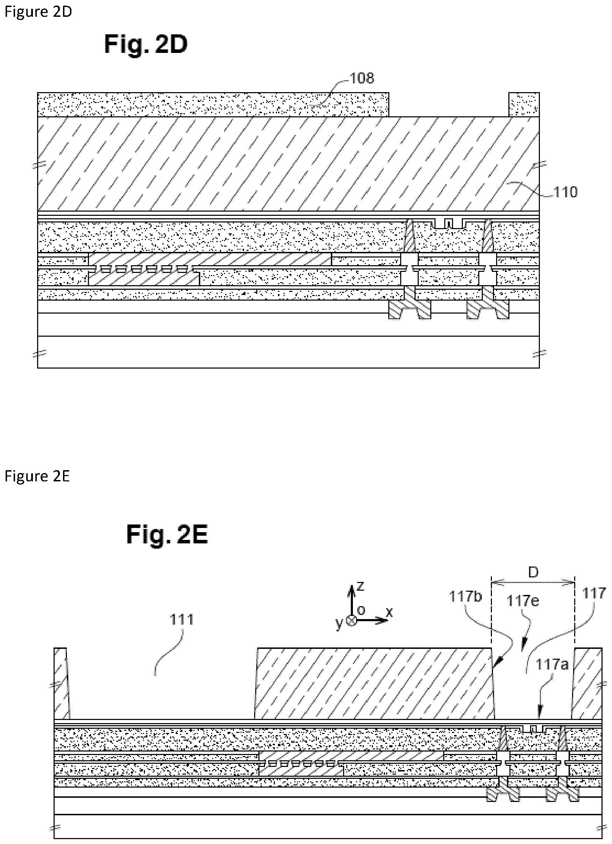

Dans l'exemple de réalisation illustré sur la figure 2D, on réalise pour cela au préalable un masque 108, par exemple en résine photosensible, sur la couche de support 10 et on reproduit les motifs du masque dans la couche de support 10. La reproduction des motifs peut être réalisée par gravure ionique réactive profonde (en anglais « Deep Reactive Ion Etching » ou DRIE) par exemple par un procédé de type communément appelé « Bosch ». Un procédé de gravure semblable à celui permettant de former des éléments de connexion à travers le silicium communément appelés TSV (pour « Through Silicon Vias ») peut être mis en œuvre. Le masque 108 est ensuite retiré.

Selon une possibilité de mise en œuvre, on peut avantageusement prévoir de réaliser concomitamment à la ou les ouvertures d'accueil de grille arrière : une ou plusieurs tranchées de découpe dans la couche de support 10.

Ainsi, dans l'exemple de réalisation illustré sur la figure 2E, outre une ouverture 117 d'accueil d'une grille arrière pour le composant C, une tranchée 111 formant un chemin de découpe est réalisée. La tranchée 111 et l'ouverture 117 de grille arrière ont ici été réalisées simultanément par gravure de la couche de support 10 du substrat à travers un même masque.

L'ouverture 117 d'accueil de la grille arrière a ici un fond 117a situé au niveau de la couche isolante 11 du substrat et dans cet exemple particulier le fond 117a est formé par cette couche isolante 11. L'ouverture 117 est pourvue de parois latérales 117b formées par la couche de support 10 semi-conductrice du substrat. On peut prévoir une ouverture 117 de diamètre D (dimension mesurée parallèlement au plan [O; x; y] du repère orthogonal [O ; x ;y ;z] donné sur la figure 2E) au niveau de son embouchure qui peut être comprise entre 500 et 10 µm, par exemple de 20 µm. L'ouverture 117 est réalisée avec une profondeur H (dimension mesurée parallèlement à l'axe z du repère orthogonal [O ; x;y;z] donné sur la figure 2E) du fond 117a jusqu'à son embouchure 117e qui peut être de l'ordre de l'épaisseur de la couche de support 10, par exemple de l'ordre 120 µm.

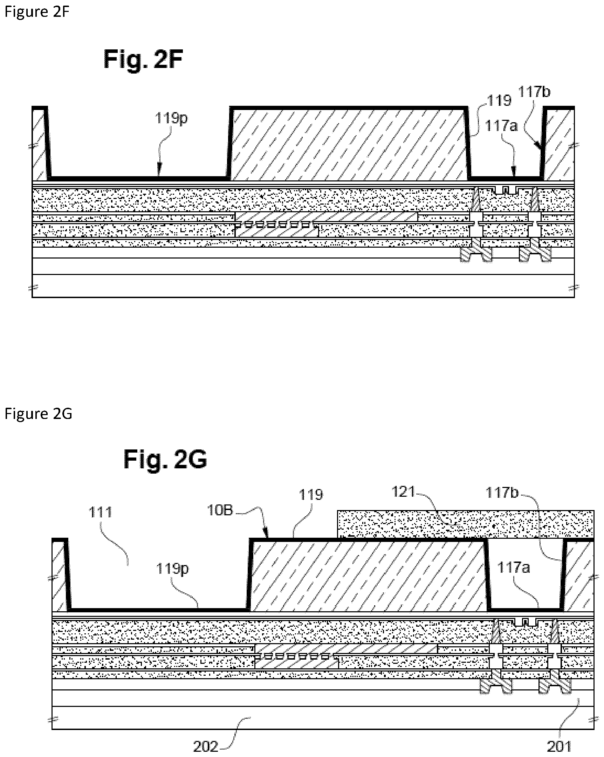

On dépose ensuite au moins un matériau conducteur dans l'ouverture 117 d'accueil de la grille (figure 2F). Dans l'exemple de réalisation illustré, on effectue cela par un procédé de dépôt conforme d'au moins une couche conductrice 119. On choisit de préférence une couche ou un empilement en matériau ayant des propriétés supraconductrices, en particulier à une température T inférieure à 2K.

La couche conductrice 119 peut être formée d'un empilement comprenant une couche d'accroche, par exemple en Ti, et d'une couche métallique, par exemple en Cu ou en un matériau ayant des propriétés surpra-conductrices et de préférence apte à être aisément déposée de manière conforme, par exemple un matériau choisi parmi l'un des matériaux suivants : TiN, Ru, Nb. Cet empilement tapisse le fond 117a et les parois latérales 117b de l'ouverture 117. On peut prévoir une couche d'accroche d'épaisseur entre 5 nm et 500 nm, par exemple de l'ordre de 50 nm, et une couche métallique en matériau ayant des propriétés supraconductrices d'épaisseur entre 5 nm et 500 nm, par exemple de l'ordre de 50 nm, l'épaisseur de ces couches étant prévue en fonction des dimensions de l'ouverture 117 et de préférence de sorte à tapisser cette dernière sans la remplir.

Dans cet exemple de réalisation, la couche conductrice 119 est ainsi en contact avec un matériau semi-conducteur au niveau des parois latérales 117b et avec un matériau isolant au niveau du fond 117a, et en particulier le matériau isolant de la couche isolante 11 du substrat. La couche conductrice 119 peut être réalisée par technique de dépôt physique en phase vapeur (PVD pour « Physical Vapor Deposition ») ou avantageusement par dépôt CVD (« Chemical vapor déposition », i.e. dépôt chimique en phase vapeur). Un procédé particulier prévoit de réaliser une couche d'accroche par iPVD (« ionised PVD ») et la couche de supra-conducteur par CVD.

On effectue ainsi une métallisation sans avoir besoin de réaliser une isolation électrique au niveau des parois latérales 117b dans la mesure où le matériau semi-conducteur de la couche de support 10, typiquement du silicium, est isolant à la température de fonctionnement du dispositif quantique. Ce dispositif quantique peut fonctionner à faible température en particulier à des températures inférieures à plusieurs Kelvin, avantageusement inférieures à 2 K et par exemple égale à 1K.

Une étape optionnelle de retrait de la couche conductrice 119 au niveau de la tranchée 111 de découpe peut être ensuite effectuée. Dans l'exemple de réalisation particulier illustré sur la figure 2G, un masquage 121 est disposé du côté de la face inférieure 10B de la couche de support 10 et au-dessus de l'ouverture 117, sans revêtir les parois latérales 117b ou le fond 117a de cette dernière. Selon un exemple particulier de réalisation, le masquage 121 peut être une couche sèche de résine photosensible réalisée par laminage, telle que par exemple une résine MX5015^{™} développée par la société Dupont^{™}.

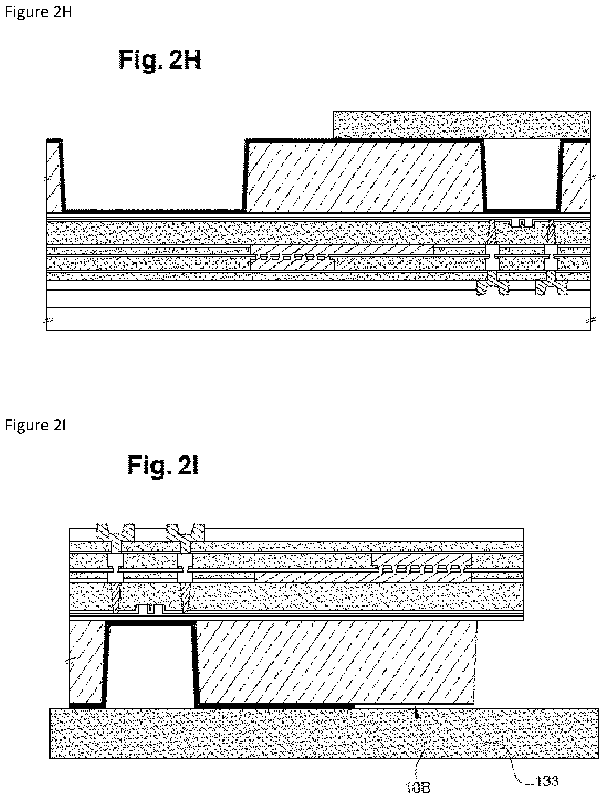

On grave ensuite des portions 119p de la couche conductrice 119 qui ne sont pas recouvertes par le masquage 121 et qui sont ainsi dévoilées. On retire en particulier ces portions 119p au niveau de la ou des tranchée(s) 111 formée(s) dans la couche de support 10 (figure 2H). Le retrait de portions 119p de la couche conductrice 119 hors de zones où l'on souhaite former la ou les grilles arrière et d'éventuelles prises de contact pour cette ou ces grilles, permet de libérer les contraintes exercées par la couche 119 sur la structure.

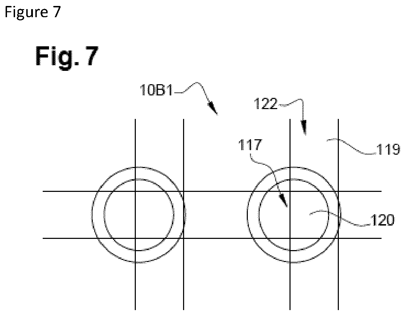

Cette étape peut être également l'occasion de réaliser des motifs 122 dans la couche conductrice 119 au niveau de la face inférieure 10B de la couche 10 de support. Cela peut permettre de définir des plots de contacts en face arrière ainsi que des zones distinctes de polarisation de la grille arrière. Cela peut également permettre de libérer la contrainte exercée par la couche conductrice 119 sur le reste de la structure. Par rapport à une réalisation d'un plan continue, Cela peut également permettre de réduire les capacités parasites. Un exemple de réalisation particulier est illustré sur la figure 7, les motifs 122 étant ici sous forme de croisements de bandes métalliques au niveau desquelles les grilles arrière 120 sont agencées.

Le masquage 121peut être ensuite retiré.

Puis, on réalise une division du substrat en plusieurs parties afin de séparer entre eux des circuits intégrés formés sur ce substrat. La division est réalisée en suivant le ou les chemin(s) de découpe(s) réalisé(s) précédemment. Une telle division peut être réalisée par un procédé de découpe mettant en œuvre des étapes de rayage et rupture, de sciage mécanique, ou de découpe au laser.

Préalablement à cette division, on peut effectuer un retrait du support 202 temporaire et de la colle 201 utilisée pour assembler ce support 202 avec l'empilement de couches formé sur le substrat, et on forme ou on colle une bande souple 133 adhésive du côté de la face inférieure 10B de la couche de support 10 (figure 2I). La bande 133 adhésive est avantageusement une bande étirable ayant une épaisseur et une composition prévues pour lui permettre d'être extensible. Par exemple, la bande adhésive peut être à base d'une polyoléfine, d'Acrylique, de PET (poly(téréphtalate d'éthylène)), ou selon un exemple de réalisation particulier être une bande adhésive de la marque « Furukawa Electric » se trouvant dans le commerce sous la référence SP-537T.

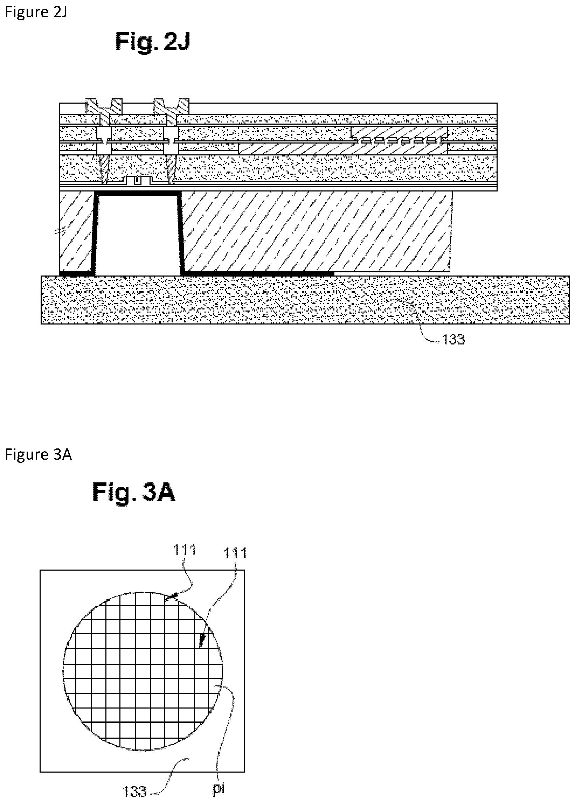

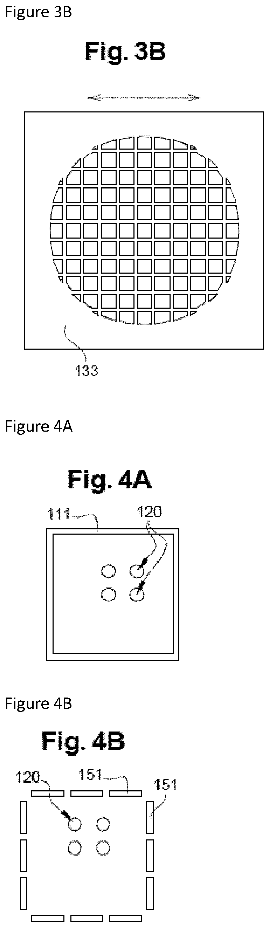

Lorsque la découpe du substrat est réalisée, par exemple par un procédé de sciage ou de découpe, la bande 133 permet de maintenir solidaire l'ensemble de manière provisoire. En variante ou en combinaison, on peut effectuer la division en étirant la bande 133 adhésive. Ainsi, dans l'exemple de réalisation illustré sur les figures 3A-3B, on étire la bande 133 adhésive pour permettre de séparer des parties du substrat correspondant à différentes puces élémentaires pᵢ et la division est mise en œuvre sans autre découpe. La réalisation préalable de tranchées 111 de découpe en combinaison avec une dilation de la bande adhésive 133 peut suffire.

Une fois que la division est réalisée, on peut ensuite réaliser la séparation (figure 2J) complète des puces élémentaires pi de circuits les unes par rapport aux autres, en retirant la bande 133 de la surface de ces dernières.

Dans l'exemple de réalisation décrit précédemment, on forme de manière avantageuse, au moins une tranchée 111 de découpe concomitamment à l'ouverture 117 d'accueil de la grille arrière. En variante, deux étapes distinctes peuvent être prévues pour réaliser l'ouverture et le chemin de découpe.

Selon une possibilité d'agencement et afin de faciliter la découpe, la tranchée 111 peut être formée de manière à réaliser un contour fermé, par exemple de forme rectangulaire ou carrée. Ainsi, dans l'exemple de réalisation illustré sur la figure 4A donnant une vue de dessous schématique, la tranchée 111 de séparation entre une puce de circuit intégré et d'autres puces de circuit adjacentes réalise un contour fermé autour de grilles arrières 120.

Pour réaliser le ou les chemins de découpe, à la place d'une tranchée continue réalisant un contour fermé, on peut prévoir de graver une succession de tranchées 151 distinctes autour de la ou les grilles 120 arrières. Dans l'exemple de réalisation illustré sur la figure 4B, les tranchées 151 formées sont disjointes les unes des autres et réalisent un contour discontinu autour d'un ensemble de grilles 120 arrières.

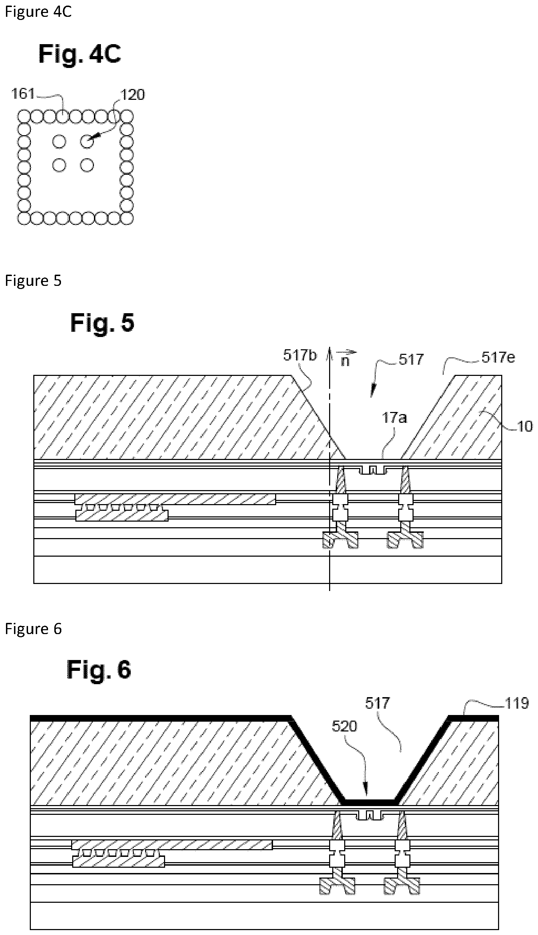

Le chemin de découpe n'est pas nécessairement limité à une topographie de tranchée(s). Ce chemin peut être réalisé sous forme d'une pluralité de trous 161. Dans l'exemple de réalisation particulier illustré sur la figure 4C, les trous 161 sont disposés les uns contre les autres de sorte à réaliser un contour qui peut être continu autour des grilles 120.

En variante de l'un ou l'autre des exemples de procédé décrits précédemment, et en particulier d'une étape telle que présentée en lien avec la figure 2E, on peut prévoir, comme sur la figure 5, de réaliser une ouverture 517 d'accueil de la grille arrière ayant une forme évasée.

Les dimensions d'une telle ouverture 517 augmentent ainsi du fond 17a situé au niveau de la couche isolante 11 du substrat jusqu'à son embouchure 517e de l'ouverture 517 et qui peut être située au niveau de la face inférieure 10B de la couche de support 10. L'ouverture est dans l'exemple illustré pourvue de parois latérales 517b de inclinées par rapport à une normale n à un plan principal de ladite couche 10 de support (i.e. un plan passant par la couche de support et parallèle au plan [O ;x ;y ;z] donné sur la figure 5. Une telle forme d'ouverture peut permettre de favoriser la réalisation de l'électrode de grille arrière en ce qu'elle rend le dépôt conforme de la couche conductrice 119 plus aisé. Pour former une telle ouverture 517, une gravure de la couche de support 10 selon un procédé de type « tapered via ») peut être réalisé. En particulier, on utilise par exemple une gravure de type DRIE-ICP (« Deep Reactive Ion Etching » - « Inductively coupled plasma », i.e. gravure ionique réactive profonde utilisant un plasma à couplage inductif. Une telle forme permet également de rendre plus aisée la réalisation par gravure de l'ouverture et peut également d'éviter une éventuelle étape préalable d'amincissement de la couche de support 10 du substrat ou d'en diminuer l'épaisseur de substrat 10 à retirer.

Un agencement de grille arrière 520 formée dans une telle ouverture 517 d'accueil est illustrée sur la figure 6. La grille arrière 520 est formée de la couche conductrice 119 tapissant le fond ainsi que les parois latérales 517b inclinées sans toutefois remplir l'ouverture 517. Une telle forme d'ouverture 517 permet également de limiter la contrainte mécanique au niveau de la couche isolante 11 du support 10 et d'obtenir ainsi une meilleure tenue de la couche conductrice 119 au fond de l'ouverture.

Un dispositif quantique à ilot ou boites quantique tel que décrit précédemment peut être amené à être intégré par exemple dans un circuit logique adapté pour mettre en œuvre un traitement quantique de l'information ou un circuit de spintronique, voir même à un circuit utilisé dans un ordinateur quantique. Un tel circuit peut être également associé ou comprendre un ou plusieurs transistors, notamment des transistors réalisés en technologie CMOS, plus particulièrement des transistors réalisés sur film mince.

## Revendications

1. Dispositif quantique à Qbits de spin comprenant un substrat (10) de type semi-conducteur sur isolant, le substrat étant doté d'une couche semi-conductrice superficielle (12), la couche semi-conductrice superficielle étant disposée sur une couche isolante (11), la couche isolante étant agencée sur une face supérieure (10A) d'une couche de support (10) semi-conductrice, le dispositif étant muni d'au moins un composant (C) formé d'un ou plusieurs ilots (12A) quantiques s'étendant dans la couche semi-conductrice superficielle (12) et d'une ou plusieurs grilles (20A, 20B) dites « avant » pour le contrôle électrostatique des ilots quantiques, la ou lesdites grilles avant (20A, 20B) étant disposée(s) sur la couche semi-conductrice superficielle (12), le composant (C) étant doté en outre d'une grille (120) de contrôle électrostatique dite « arrière », ladite grille de contrôle arrière étant formée d'une couche conductrice (119) tapissant des parois latérales (117b) et un fond (117a) d'une ouverture (117, 517), la dite ouverture traversant ladite couche de support (10) semi-conductrice depuis une face inférieure (10B) de ladite couche de support opposée à ladite face supérieure (10A) jusqu'à ladite couche isolante (11) du substrat, ladite couche conductrice (119, 519) étant disposée, au fond de l'ouverture (117, 517), contre et avantageusement en contact avec ladite couche isolante du substrat, ladite couche conductrice (119, 519) étant disposée contre et en contact avec ladite couche (10) de support semi-conductrice au niveau desdites parois latérales de ladite ouverture, ladite ouverture (517) ayant des parois latérales (517b) inclinées par rapport à une normal (n) à un plan principal de ladite couche (10) de support.

2. Dispositif quantique à Qbits de spin selon la revendication 1, dans ladite ouverture (117) comporte un volume vide qui s'étend de la couche conductrice (119) jusqu'à une embouchure de ladite ouverture (117).

3. Dispositif quantique à Qbits de spin selon l'une des revendications 1 ou 2, dans lequel la couche conductrice (119) s'étend en outre au-delà de ladite ouverture (117) sur ladite face inférieure (10B) de la couche de support.

4. Dispositif quantique à Qbits de spin selon l'une des revendications 1 à 3, dans lequel la couche conductrice (119) s'étend sur une région donnée (10B1) de ladite face inférieure (10B) de la couche de support (10) et est structurée de sorte à comporter des motifs (122) sur cette région donnée.

5. Dispositif quantique à Qbits de spin selon l'une des revendications 1 à 4, dans lequel la couche conductrice (119) est formée d'un empilement comprenant une couche d'accroche conductrice, et une couche métallique en un matériau ayant des propriétés supra-conductrices.

6. Procédé de fabrication d'un dispositif quantique à Qbits de spin selon l'une des revendications 1 à 5, comprenant, dans cet ordre, des étapes suivantes :
a) prévoir ou réaliser une structure comprenant, ledit substrat muni desdits un ou plusieurs ilots quantiques (12A, 12B) s'étendant dans la couche semi-conductrice (12) superficielle et desdites une ou plusieurs grilles (20A, 20B) de contrôle électrostatique avant des ilots quantiques disposées sur la couche semi-conductrice superficielle,
b) former, à travers la face inférieure de ladite couche de support (10), ladite ouverture (117), ladite ouverture (517) ayant des parois latérales (517b) inclinées par rapport à une normal (n) à un plan principal de ladite couche (10) de support et réaliser un ou plusieurs trous (161) ou tranchées (111, 151) de découpe, dans la couche de support (10) de sorte à réaliser un chemin de découpe dans ladite couche de support, la réalisation desdits un ou plusieurs trous (161) de découpe ou tranchées (111, 151) de découpe dans la couche de support (10) et la formation de ladite ouverture (117) étant réalisées par gravure et de manière concomitante,
puis,
c) déposer ladite couche conductrice dans ladite ouverture de sorte à former la grille de contrôle électrostatique arrière.

7. Procédé selon la revendication 6, dans lequel lesdits un ou plusieurs trous (161) ou tranchée(s) (111, 151) de découpe réalisent un contour autour de ladite ouverture.

8. Procédé selon l'une des revendications 6 ou 7, dans lequel le dépôt de ladite couche conductrice (119) est réalisé également dans lesdits un ou plusieurs trous (161) ou tranchée(s) (111, 151) de découpe,
le procédé comprenant en outre des étapes de :
- formation d'un masquage (121) recouvrant ladite ouverture (117),
- retrait par gravure de ladite couche conductrice (119) en regard du ou des trous ou tranchée(s) de découpe tout en protégeant ladite ouverture (117) par le biais dudit masquage (121).

9. Procédé selon l'une des revendications 6 à 8, comprenant en outre, après l'étape c) des étapes de :
- collage d'une bande adhésive (133) contre la face inférieure ou une couche ou un empilement disposé(e) sur la face inférieure de la couche de support,
- étirement de la bande adhésive (133) de sorte à réaliser une division du substrat au niveau du ou des chemins de découpe.

10. Procédé selon l'une des revendications 6 à 9, dans lequel l'ouverture (117) est réalisée par gravure profonde à travers un masque (108).

11. Procédé selon l'une des revendications 6 à 10, dans lequel lesdites une ou plusieurs grilles de contrôle électrostatique avant sont revêtues d'un empilement de couches et dans lequel entre l'étape a) et l'étape b) on colle un support poignée temporaire sur ledit empilement, le procédé comprenant en outre après l'étape c) une étape de retrait dudit support temporaire.
